# EUROPEAN PATENT SPECIFICATION

(11) **EP 2 057 869 B1**
(45) Date of publication and mention of the grant of the patent: **13.06.2012**
(21) Application number: 07774769.9
(22) Date of filing: 04.04.2007
(51) Int. Cl.: H05K 1/16, H01L 23/50

(54) **POWER CORE DEVICES AND METHODS OF MAKING THEREOF**
LEISTUNGSKERNEINRICHTUNGEN UND HERSTELLUNGSVERFAHREN DAFÜR
DISPOSITIFS DE CENTRE D'ÉNERGIE ET LEURS PROCÉDÉS DE FABRICATION

(30) Priority: 31.08.2006 US 514094
(43) Date of publication of application: 13.05.2009
(73) Proprietor: CDA Processing Limited Liability Company, Wilmington DE 19808 (US)
(72) Inventor: AMEY, Daniel, I., Durham, North Carolina 27705 (US); BORLAND, William, Chapel Hill, North Carolina 27517 (US)
(74) Representative: Carpmaels & Ransford
(86) International application number: PCT/US2007/008483
(87) International publication number: WO 2008/027080

(56) References cited:
- EP-A- 1 675 449
- US-A1- 2002 085 334
- US-B1- 6 346 743
- US-B1- 6 388 207

## Description

### FIELD OF THE INVENTION

The technical field relates to devices having both low inductance and high capacitance functions, and methods of incorporating such devices in power core packages, including organic dielectric laminates and printed wiring boards.

### TECHNICAL BACKGROUND OF THE INVENTION

Since semiconductor devices including Integrated circuits (IC) operate at increasingly higher frequencies and data rates and at lower voltages, the production of noise in the power and ground (return) lines and the need to supply sufficient current to accommodate faster circuit switching become an increasingly important problem. In order to provide low noise and stable power to the IC, low impedance in the power distribution system is required. In conventional circuits, impedance is reduced by the use of additional surface mount capacitors interconnected in parallel. The higher operating frequencies (higher IC switching speeds) mean that voltage response times to the IC must be faster. Lower operating voltages require that allowable voltage variations (ripple) and noise become smaller. For example, as a microprocessor IC switches and begins an operation, it calls for power to support the switching circuits. If the response time of the voltage supply is too slow, the microprocessor will experience a voltage drop or power droop that will exceed the allowable ripple voltage and noise margin; the IC will malfunction. Additionally, as the IC powers up, a slow response time will result in power overshoot. Power droop and overshoot must be controlled within allowable limits by the use of capacitors that are close enough to the IC to provide or absorb power within the appropriate response time.

capacitors for impedance reduction and minimizing power droop or dampening overshoot are generally placed as close to the IC as possible to improve circuit performance. Conventional designs for capacitor placement mount capacitors on the surface of a printed wiring board (PWB) clustered around the IC. Large value capacitors are placed near the power supply, mid-range value capacitors at locations between the IC and the power supply, and small value capacitors very near the IC. This distribution of capacitors is designed to reduce voltage response time as power moves from the power supply to the IC.

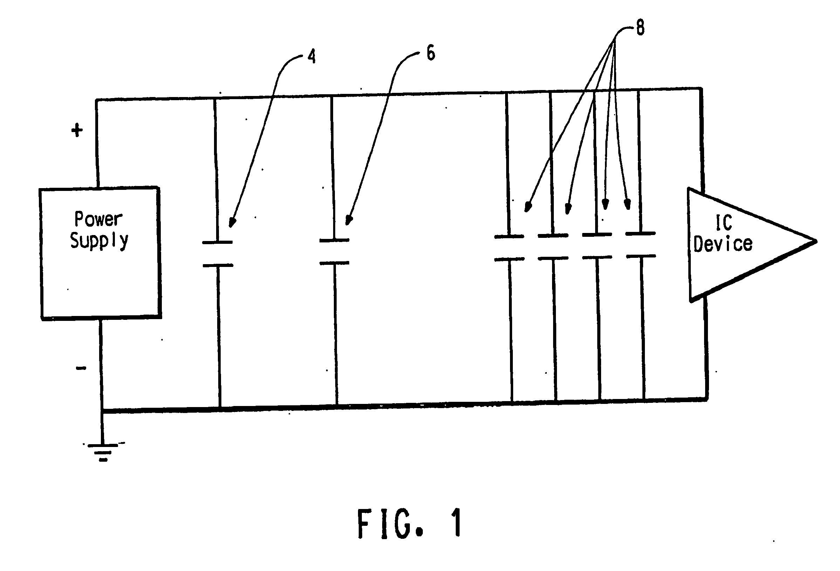

**FIG. 1** is a schematic illustration for a typical placement of capacitors. Shown is a power supply, an IC and the capacitors **4, 6, 8**, which represent high value, mid-range value and small value capacitors, respectively, used for impedance reduction and minimizing power droop and dampening overshoot as described above.

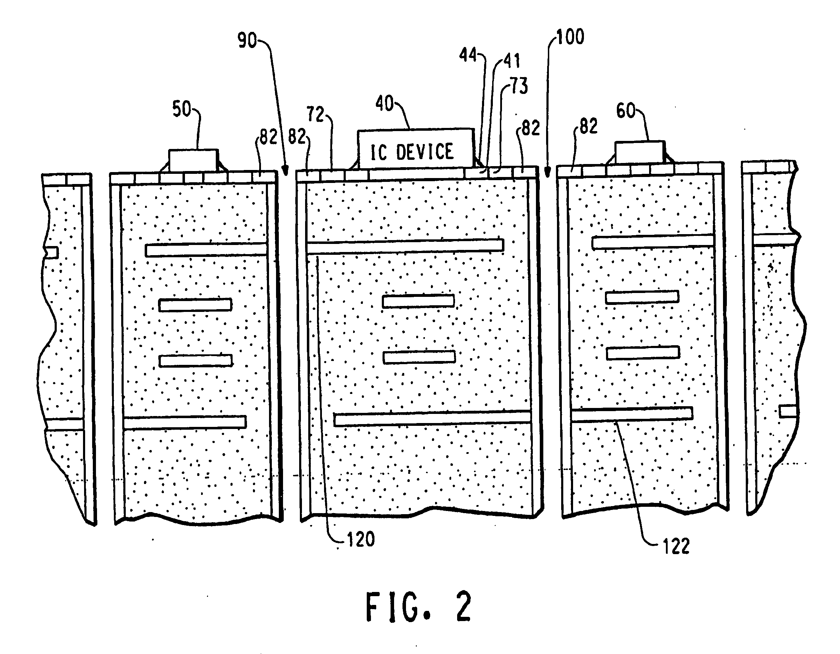

**FIG. 2** is a representative section view in front elevation showing the connections of Surface Mount Technology (SMT) capacitors **50** and **60** and IC device **40** to the power and ground planes in the substrate of the PWB. IC device **40** is connected to lands 41 by solder filets **44**. Lands **41** are connected to plated-through hole via pads **82** of vias **90** and **100** by circuit lines **72** and **73**. Via **90** is electrically connected to conductor plane **120** and via 100 is connected to conductor plane **122**. Conductor planes **120** and **122** are connected one to the power or voltage side of the power supply and the other to the ground or return side of the power supply. Small value capacitors **50** and **60** are similarly electrically connected to vias and conductor planes **120** and **122** in such a way.that they are electrically connected to **IC** device **40** in parallel. In the case of IC devices placed on modules, interposers, or packages, the large and medium value capacitors may reside on the printed wiring mother board to which the modules, interposers, or packages are attached.

A large number of capacitors, interconnected in parallel, is often needed to reduce power system impedance. This requires complex electrical routing, which leads to increased circuit loop inductance, In turn this increases impedance, constraining current flow, thereby reducing the beneficial effects of surface mounted capacitors. As frequencies increase and operating voltages continue to drop, increased power must be supplied at faster rates requiring increasingly lower inductance and impedance levels.

Considerable effort has been expended to minimize impedance. US 5,161,086 to Howard, et al., provides one approach to minimizing impedance and "noise". Howard, et al. discloses a capacitive printed circuit board with a capacitor laminate (planar capacitor) placed within the multiple layers of the laminated board with a large number of devices such as integrated circuits being mounted or formed on the board and operatively coupled with the capacitor laminate (or multiple capacitor laminates) to provide a capacitive function employing borrowed or shared capacitance. However, such an approach to capacitor placement does not provide for high capacitance and does not necessarily improve voltage response. Improved voltage response requires that the capacitor be placed closer to the IC. Moreover, simply placing the capacitor laminate closer to the IC is not a satisfactory technical solution to provide high capacitance because the total capacitance available may be insufficient.

U.S. 6,611,419 to Chakravorty discloses an alternate approach to embedding capacitors to reduce switching noise. The power supply terminals of an integrated circuit die can be coupled to the respective terminals of at least one embedded capacitor in a multilayer ceramic substrate.

EP 1675449 relates to decoupling devices having both low inductance and high capacitance functions, wherein a power core comprises at least one singulated capacitor layer containing at least one embedded singulated capacitor.

Accordingly, the present inventors desired to provide a power core that allows for impedance reduction combined with improved voltage response to accommodate higher IC switching speeds. The present invention provides such a device and method of making such a device.

### SUMMARY

The present invention is directed to an assembly comprising a power core, a semiconductor device and a printed wiring motherboard, said power core having an outer layer, said power core comprising at least one embedded singulated capacitor layer containing multiple singulated capacitors wherein said multiple embedded singulated capacitors each comprise at least a first embedded singulated capacitor electrode and a second embedded singulated capacitor electrode and wherein said multiple embedded singulated capacitors are positioned on said outer layer of said power core and wherein said first embedded singulated capacitor electrodes and said second embedded singulated capacitor electrodes of said multiple embedded singulated capacitors of said at least one embedded singulated capacitor layer are each directly connected to at least one Vcc (power) terminal and at least one Vss (ground) terminal, respectively, of the semiconductor device and characterised in that said first embedded singulated capacitor electrodes and said second embedded singulated capacitor electrodes of said multiple embedded singulated capacitors of said at least one embedded singulated capacitor layer are each interconnected to a first external planar capacitor electrode and a second external planar capacitor electrode, respectively, of an external planar capacitor embedded within the printed wiring motherboard on which said power core is placed and wherein said printed wiring motherboard serves to supply a charge to said multiple embedded singulated capacitors; wherein the external planar capacitor embedded in the motherboard is larger than the power core.

### BRIEF DESCRIPTION OF THE DRAWINGS

The detailed description will refer to the following drawings, wherein like numerals refer to like elements, and wherein:
FIG. 1 is a schematic illustration of typical prior art use of capacitors for impedance reduction and reducing power droop or dampening overshoot.
FIG. 2 is a representation in section view in front elevation of a printed wiring board assembly having conventional prior art surface mount (SMT) capacitors used for impedance reduction and reducing power droop or dampening overshoot.
**FIG. 3** shows the typical arrangement of Vcc(power) and Vss (ground) connections of the layout of a BGA assembly, such as a Pentium® 4 processor package.
**FIG. 4** is a plan view of a portion of the power core device according to the first embodiment showing how electrode pads of the singulated capacitors are aligned to the layout shown in **FIG. 3**
**FIG. 5** is a representation in section view across line a-a of **FIG. 4** in front elevation of a portion of a power core device according to the first embodiment wherein the electrodes of the capacitor on the outer layer have been connected in parallel to the electrodes of the planar capacitor laminate within the printed wiring motherboard.
**FIG. 6** is a representation in section view across line b-b of **FIG 4** in front elevation of a portion of a power core device according to the first embodiment wherein the electrodes of the capacitor on the outer layer have been connected in parallel to the electrodes of the planar capacitor laminate within the printed wiring motherboard.
**FIG. 7** is a representation in section view across line c-c of **FIG 4** in front elevation of a portion of a power core device according to the first embodiment wherein the electrodes of the capacitor on the outer layer have been connected in parallel to the electrodes of the planar capacitor laminate within the printed wiring motherboard.
**FIGS. 8A-8G** illustrate a method of making singulated thin-film fired-on-foil capacitors and laminating them to a PWB core wherein the singulated capacitors are on the outer metal layer of the PWB.**FIG. 9** is a representation in section view in front elevation of a finished power core structure according to the method of **FIG. 8 - 8G** wherein the singulated capacitors are on the outer metal layer of the power core device and have been interconnected by microvias to pads on the bottom surface of the power core device.

### DETAILED DESCRIPTION

As used herein, "fired-on-foil capacitors" refers to capacitors that is formed by firing a deposited dielectric layer on a metallic foil at an elevated temperature to crystallize and sinter the dielectric to form a high dielectric constant layer. A top electrode may be deposited before or after firing the dielectric to form the capacitor. The embedded singulated capacitors may be formed by other methods and are simply formed-on-foil. Typically, a firing process is used and therefore the term "fired-on-foil" is used in the Detailed Description, but it is not intended to be limiting.

As used herein, the term "printed wiring board (PWB) core" refers to a printed wiring board structure that is formed from at least one inner layer PWB laminate structure that comprises at least one prepreg/metal layer that may contain circuitry. A PWB core is typically used as the base for additional metal/dielectric layers that are built up or sequentially added to the core.

As used herein, the terms "high dielectric constant materials" or "high K, thin-film capacitor dielectric materials" refer to materials that have a bulk dielectric constant above 500 and can comprise perovskite-type ferroelectric compositions with the general formula ABO₃. Examples of such compositions include BaTiO₃; BaSrTiO₃; PbTiO₃; PbTiZrO₃; BaZrO₃ SrZrO₃; and mixtures thereof. Other compositions are also possible by substitution of alternative elements into the A and/or B position, such as Pb(Mg_{1/3} Nb_{2/3})O₃ and Pb(Zn_{1/3} Nb_{2/3})O₃ and mixtures thereof. Mixed metal versions of the above compositions are also suitable.

As used herein, the term "printed wiring board", "PWB" or "printed wiring board device" refers to an interposer, multichip module, area array package, semiconductor package, system-on package, system-in-package, and the like or a device used as such.

As used herein, the term "printed wiring motherboard" refers to a large printed wiring board that the printed wiring board as defined above, is generally placed on and interconnected to. The printed wiring motherboard comprises at least one planar capacitor (i.e., the external planar capacitor) which serves as a planar capacitor external to the power core and which is interconnected to and supplies power to the embedded singulated capacitor(s) of the power core. The printed wiring motherboard planar capacitor comprises a first printed wiring motherboard planar capacitor electrode and a second printed wiring motherboard planar capacitor electrode. Motherboard, mother board, or printed wiring motherboard, as used herein, includes boards or cards.

As used herein, the term "semiconductor device" includes microprocessors, processors, graphic processors, memory controllers, input/output controllers, ASICs, gate arrays and devices performing similar functions. A semiconductor device comprises at least one Vcc(power) terminal and at least one Vss(ground) terminal.

As used herein, the term "power core" comprises at least one embedded singulated capacitor wherein said power core has an outer layer. The outer layer of the power core refers to the outer most surface of the power core placed in closest proximity to the semiconductor device.

As used herein, the term "planar capacitor" refers to a foil/dielectric/foil laminate capacitor structure wherein both foils are common electrodes.

As used herein, "singulated capacitors" refers to individual capacitors formed on metal foil. Multiple singulated capacitors may or may not have one common electrode.

As used herein, the term "foil" encompasses a general metal layer, plated metal, sputtered metal, etc.

According to a first embodiment, a design of a power core device is disclosed in which electrodes of singulated capacitors on the outer layer of a power core are connected in parallel to the electrodes of a planar capacitor external to the power core and in a printed wiring motherboard.

The singulated capacitors in the power core structure are designed to be on the outer layer of the device so that the Vcc (power) terminals and the Vss (ground) terminals of the semiconductor device, such as a microprocessor, are aligned with and may be connected directly to the first and second electrodes of the singulated capacitor. The second electrodes of the singulated capacitors may be common or may be separated. Placing the singulated capacitors on the outer layer also provides for low inductance connections.

The first and second electrode of the singulated capacitors are in turn connected to the power and ground planes respectively of the external planar capacitor embedded in the printed wiring motherboard. The planar capacitor is used as the power-ground planes and the power-ground plane separation is made thin to maximimize capacitance density to provide rapid charging of the singulated capacitors. The mother board is quite large relative to the PWB within which the singulated capacitors reside so that the planar capacitor is large, thus having the ability to supply considerable power to the singulated capacitors

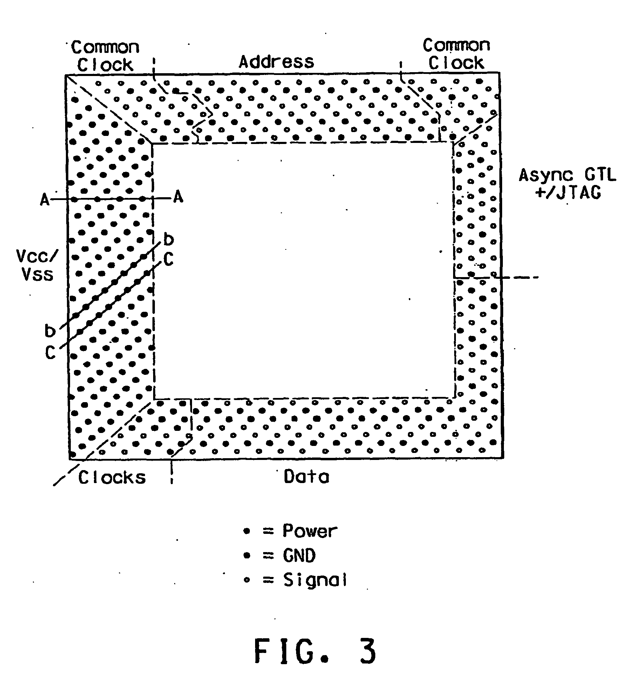

FIG. 3 shows the typical mechanical arrangement of Vcc (power). and Vss (ground) connections to the printed wiring board for a BGA assembly, such as a Pentium 4® processor package. The Vcc/Vss terminals are the area of focus for the power core.

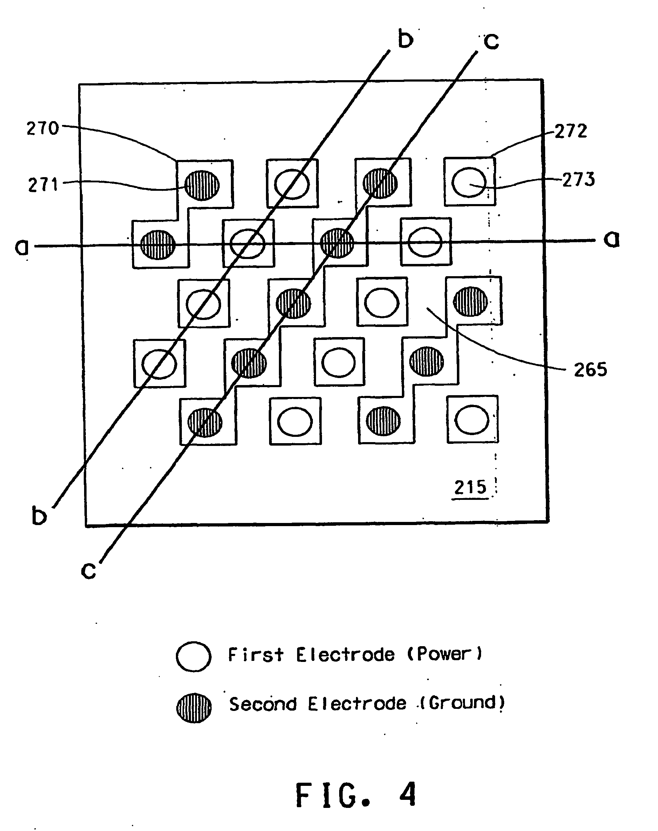

**FIG. 4** shows a top plan view of the relevant portion of the power core device according to the present embodiment. Both the first electrode **272** and second electrode **270** of the singulated capacitors are outlined in **FIG. 4**. Electrodes **272** and **270** are separated by a trench **265** formed in the underlying metal foil and are present on the surface of the power core device. The first electrodes **272**, are designed to be connected directly to the Vcc (power) terminals of the processor package. The second electrodes **270** are designed to be connected directly to the Vss (ground) terminals of the processor package and are common. The size of the electrode pads **273** and **271** are defined by soldermask **215** shown on the surface of the power core device.

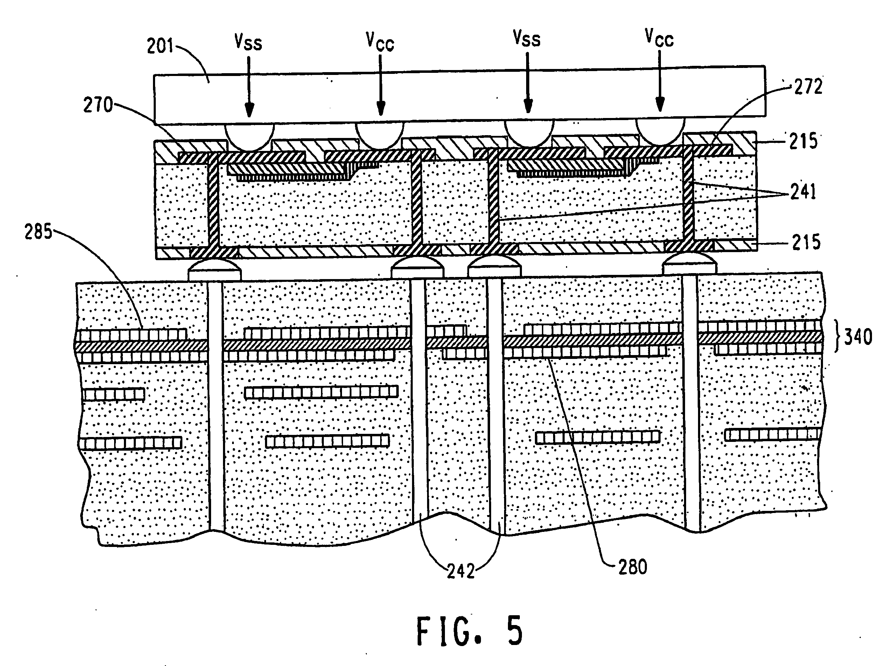

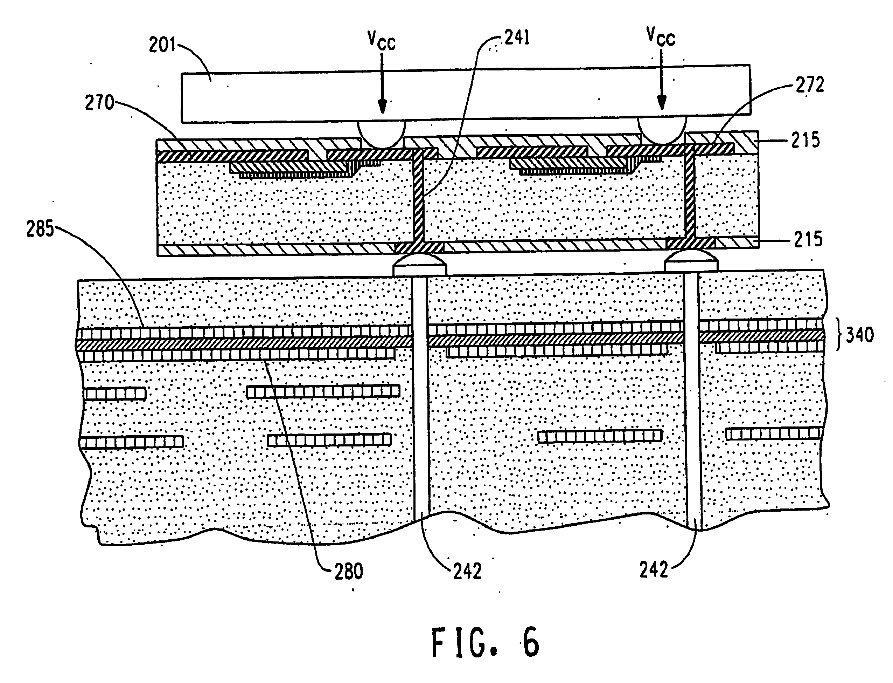

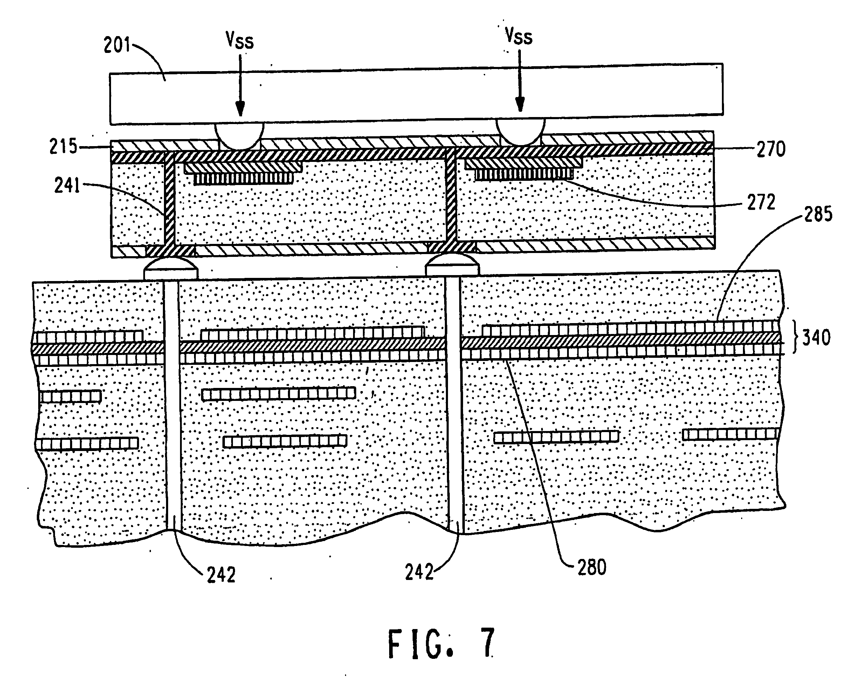

**FIGs. 5-7** are representations in section view in front elevation of the top portion of a power core structure along lines a-a, b-b, and c-c of **FIG. 4** respectively. **FIG. 5** is a partial representation; in section view across line a-a in front elevation of a power core device with an attached semiconductor device, such as a microprocessor, interconnected with a planar capacitor within a printed wiring motherboard, according to the first embodiment. The Vcc (power) terminals of the semiconductor device **201** are connected to the soldermask (**215**) defined pads **273** (shown in **FIG. 4**) of the first electrodes **272** of the singulated capacitor which in turn are connected to the power plane **285** of the planar capacitor **340** within the printed wiring motherboard by microvias **241** in the power core and vias **242** in the printed wiring motherboard. The Vss (ground) terminals of the semiconductor device **201** are connected to the soldermask **(215)** defined pads **271** (shown in **FIG. 4****)** of the second electrodes **270** of the singulated capacitor which in turn are connected to the ground plane **280** of the planar capacitor **340** within the printed wiring motherboard. **FIG. 6** is a partial representation in section view across line **b-b** in front elevation of a power core device with an attached semiconductor device, interconnected with a planar capacitor within a printed wiring motherboard, according to the first embodiment. The Vcc (power) terminals of the microprocessor **201** are connected to the soldermask **(215)** defined pads **231** (shown in **FIG. 4****)** of the first electrodes **272** of the singulated capacitor which in turn are connected to the power plane **285** of the planar capacitor **340** within the printed wiring motherboard by microvias **241** in the power core and vias **242** in the printed wiring motherboard. **FIG. 7** is a partial representation in section view across line c-c in front elevation of a power core device with an attached microprocessor, interconnected with a planar capacitor within a printed wiring motherboard, according to a first embodiment. The Vss (ground) terminals of the semiconductor device **201** are connected to the soldermask (215) defined pads 271 (shown in FIG. 4) of the common second electrode 270 of the singulated capacitors which in turn is connected to the ground plane 280 of the planar capacitor 340 within the printed wiring motherboard by microvias 241 in the power core and vias 242 in the printed wiring motherboard.

The above power core allows for a foil containing the singulated capacitors to be formed with various materials. In general, fired-on-foil techniques may be preferably employed to make singulated ceramic capacitors on foil using ceramic compositions that are fired at relatively high temperatures (typically, 700 °C to 1400 °C) to form a sintered ceramic capacitor. Such capacitors may be formed from thin-film or thick-film approaches. The foil containing said fired-on-foil capacitors may be laminated to the PWB core using standard printed wiring board lamination processes to form the power core structure.

The above power core is interconnected to the planar capacitor embedded within the printed wiring motherboard. The printed wiring motherboard is generally considerably larger than the PWB containing the singulated capacitors and hence the planar capacitor may be made large in area thereby, supporting more and improved power supply to the singulated capacitors.

The planar capacitor may be formed using various materials. Such materials may include metal foil-dielectric-metal foil laminate structures wherein the dielectric may comprise an organic layer, a ceramic-filled organic layer, or a ceramic layer. Multiple planar capacitor layers may also be used. Such dielectrics would be manufactured as thin layers, for example, between 4 microns and 25 microns, for improved capacitance density. Planar capacitors will generally reside in the upper and lower layers of the printed wiring motherboard for symmetry. Suitable planar capacitor laminates include Interra™ HK 04 Series commercially available from E. I. du Pont de Nemours and Company, Interra™ HK 11 Series commercially available from E. I. du Pont de Nemours and Company, BC-2000 and BC-1000 commercially available from laminators licensed by Sanmina, FaradFlex Series commercially available from Oak-Mitsui Technologies, InSite™ Embedded Capacitor Series commercially available from Rohm and Haas Electronic Materials, TCC™ commercially available from Gould Electronics, and-C-Ply from 3M.

According to the above embodiment, both the low impedance and high capacitance functions may be integrated into a single power core structure permitting operation of high-speed ICs at lower voltages with reduced voltage ripple. Further, the planar capacitor within the printed wiring motherboard, supplying power to the singulated capacitor, may be large relative to the PWB containing the singulated capacitors. Furthermore, solder joints associated with SMT devices may be eliminated, thereby improving reliability.

According to common practice, the various features of the drawings are not necessarily drawn to scale. Dimensions of various features may be expanded or reduced to more clearly illustrate the embodiment of the invention.

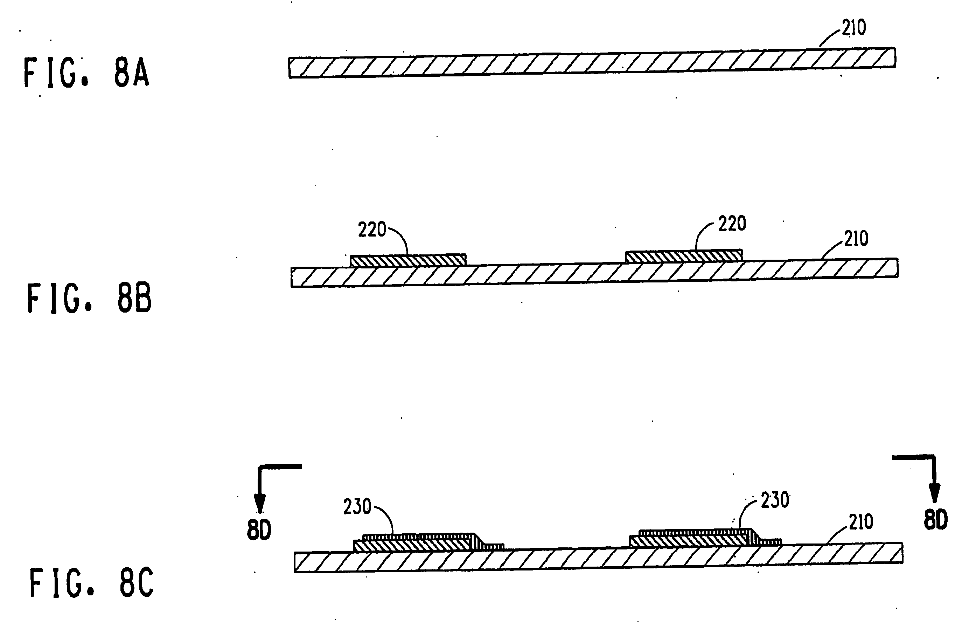

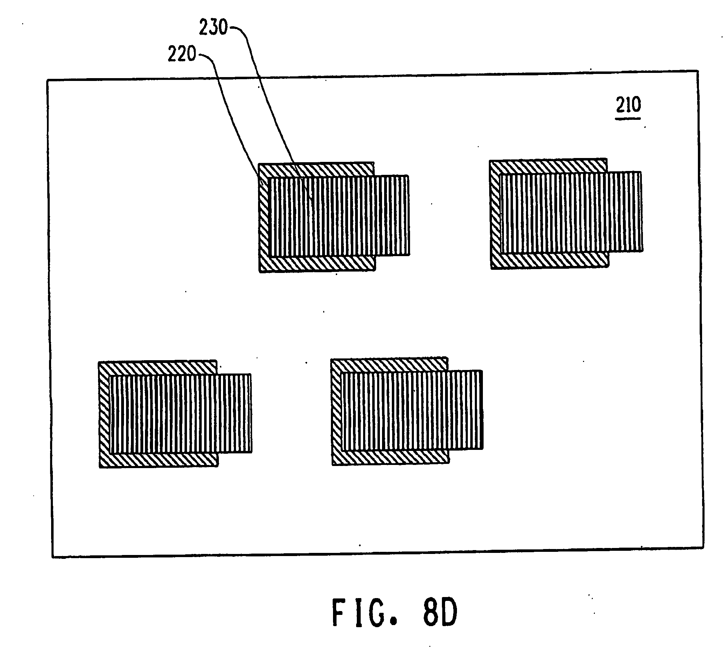

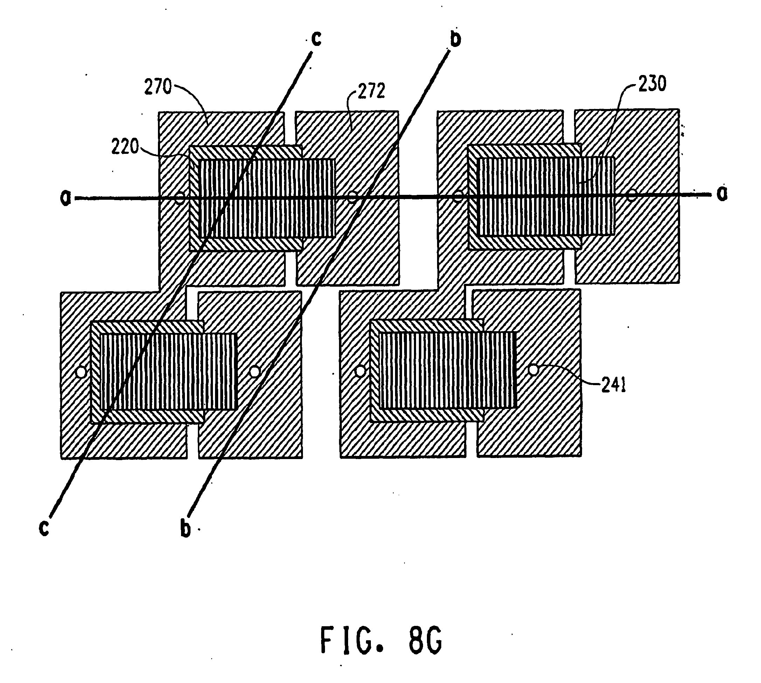

**FIGS. 8A-8G** illustrate a method of manufacturing fired-on-foil singulated capacitors and laminating them to a PWB core structure. **FIG. 8D** is a plan view of fired-on-foil capacitors. **FIG. 8G** is a plan view of the singulated capacitors after etching of the foil viewed from beneath and within the PWB. The lines a-a, b-b, and c-c from **FIGs. 3** and **4** are shown on the plan view of **FIG. 8G** to illustrate the capacitor layout. **FIGS. 8A-8G** illustrate a method wherein the dielectric is selectively- deposited on to a metallic foil in desired areas only. Alternative designs of the power core may include forming said singulated capacitors from alternative approaches. For example, the dielectric may be deposited over the entirety of the metallic foil and top electrodes deposited over the dielectric to form a series of parallel plate singulated capacitors. Such an approach would require different etching patterning and via formation approaches to connect the terminals of the semiconductor device to the respective electrodes. The electrodes would be connected with the respective planar capacitor planes in the mother board by vias in the same manner. Alternative methods, such as this, may achieve the same design requirements.

A specific example of fired-on-foil capacitors are described below to illustrate one embodiment of the present invention.

**FIG. 8A** is a side elevational view of a first stage of manufacturing singulated capacitors. **In** **FIG. 8A**, a metallic foil **210** is provided. The foil **210** may be of a type generally available in the industry. For example, the foil **210** may be copper, copper-invar-copper, invar, nickel, nickel-coated copper, or other metals that have melting points in excess of the firing temperature for the dielectric. Preferred foils include foils comprised predominantly of copper or nickel. The thickness of the foil **210** may be in the range of, for example, about 1-100 microns, preferably 3-75 microns, and most preferably 12-36 microns, corresponding to between about 1/3 oz and 1 oz copper foil. An example of a suitable copper foil is PLSP grade 1 ounce copper foil obtainable from Oak-Mitsui. An example of a suitable nickel foil is Nickel Foil **201** obtainable from Allfoils.

In **FIG. 8B**, a capacitor dielectric material is deposited onto the metal foil **210**, forming capacitor dielectric layer **220**. The capacitor dielectric material may be deposited, for example, by sputtering a suitable high dielectric constant material through a mask to define the dielectric area. Other deposition methods include coating the desired areas of the foil using a chemical solution of a high dielectric constant material. Other methods may be appropriate.

High dielectric constant, (high K) materials may: be described as materials that have bulk dielectric constant above 500 and can comprise perovskite-type ferroelectric compositions with the general formula ABO₃. Examples of such compositions include, but not limited to BaTiO₃; SrTiO₃; PbTiO₃; PbTiZrO₃; BaZrO₃ SrZrO₃; and mixtures thereof. Other compositions are also possible by substitution of alternative elements into the A and/or B position, such as Pb(Mg_{1/3} Nb_{2/3})O₃ and Pb(Zn_{1/3} Nb_{2/3})O₃and mixtures thereof. A suitable high K material is barium titanate (BaTiO₃). Doped and mixed metal versions of the above compositions are also suitable. Doping and mixing is done primarily to achieve the necessary end-use property specifications such as, for example, the necessary temperature coefficient of capacitance (TCC) in order for the material to meet industry definitions, such as "X7R" or "Z5U" standards.

The capacitor dielectric layer **220** is then fired. The firing temperature may be in the range of 700°C to 1400°C**.** The firing temperature depends on the melting point of the underlying metallic foil and the microstructural development desired in the dielectric. For example, a suitable upper firing temperature for copper is approximately 1050°C but for nickel, it can be as high as 1400°C, due to their melting points. During firing, the dielectric crystallizes in the temperature range of 500-700°C and further heating densifies the dielectric and promotes grain growth. Firing is done under a protective or reducing atmosphere sufficiently low in oxygen to afford oxidation protection to the metal foil. The exact atmosphere chosen will depend upon the temperature and the underlying metallic foil. Such protective atmospheres can be thermodynamically derived from standard free energy of formation of oxides as a function of temperature calculations or diagrams as disclosed in publication " F. D. Richardson and J.H.E. Jeffes, J. Iron Steel Inst., 160, 261 (1948). For example, using copper as the underlying metallic foil, firing at 700°C, 900°C and 1050°C would require partial pressures of oxygen (*PO*₂) of approximately less than 4 x 10⁻¹¹, 3.7 x 10⁻⁸, and 1.6 x 10⁻⁶ atmospheres respectively to protect the copper from oxidation.

In **FIG. 8C**, an electrode **230** is formed over the dielectric layer **220**. The electrode **230** can be formed by, for example, sputtering but other methods are possible. In general, the surface area of the dielectric layer **220** should be larger than that of the electrode **230**. The electrode **230** is typically deposited after the dielectric has been fired. In some cases, however, it may be deposited prior to firing of the dielectric.

**FIG. 8D** is a plan view of the article of **FIG. 8C**. In **FIG. 8D**, four dielectric layers **220** and four electrodes **230** on the foil **210** are illustrated. Any number dielectric layers **220** and electrodes **230**, in various patterns consistent with the power and ground terminals of the semiconductor device, however, can be arranged on the foil **210**.

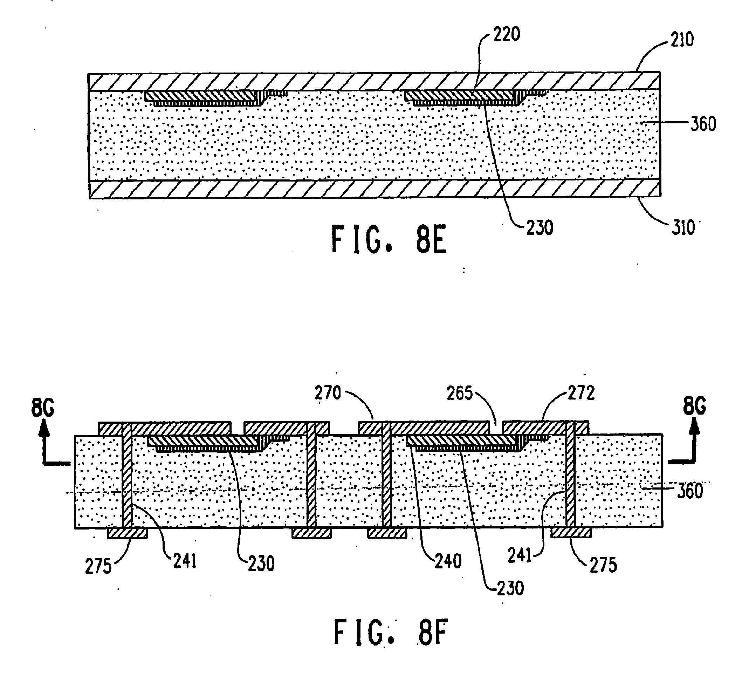

The capacitor-on-foil structure may be inverted and the component face of the foil containing dielectric layers **220** and electrode layers **230** laminated to a PWB core comprising prepreg **360** and metal foil **310** to form the power core structure shown in **FIG. 8E**. The lamination can be performed, for example, using FR4 epoxy prepreg in standard printing wiring board processes. In one embodiment, epoxy prepreg Type 106 may be used. Suitable lamination conditions may be 185°C at 208 psig for 1 hour in a vacuum chamber evacuated to 28 inches of mercury. A silicone rubber press pad and a smooth PTFE filled glass release sheet may be in contact with the foils **210** and **310** to prevent the epoxy from gluing the lamination plates together. The dielectric prepreg and laminate materials can be any type of dielectric material such as, for example, standard epoxy, high Tg epoxy, polyimide, polytetrafluoroethylene, cyanate ester resins, filled resin systems, BT epoxy, and other resins and laminates that provide electrical insulation. A release sheet may be in contact with the foils to prevent the epoxy from gluing the lamination plates together between circuit layers. The resulting structure is encapsulated by foil **210** on one side and foil **310** on the other.

Referring to **FIG. 8F**, after lamination, a photo-resist is applied to foils **210** and **310** (as shown in **FIG. 8E**). The photo-resist is imaged, developed and the metal foils are etched and the photoresist is stripped using standard printing wiring board processing conditions. The etching produces a trench **265** in the foil **210**, which breaks electrical contact between the first electrode **230** and the foil **210** creating two surface electrodes **270** and **272** from foil **210**. Microvias **241** are also drilled and plated at this time. Any associated circuitry is also created from foil **210** that may be used as signal or power distribution circuitry. The etching also produces pads **275** and any associated circuitry from foil **310**.

**FIG. 8G** is a plan view of the singulated capacitors after etching of the foil. **FIG. 8G** is viewed from beneath and within the PWB of **FIG. 8F**. The lines a-a, b-b, and c-c from **FIGs. 3** and **4** are shown on the plan to illustrate the layout of dielectric layers **220** and electrode **270** and **272** and microvias **241** with respect to the microprocessor terminals.

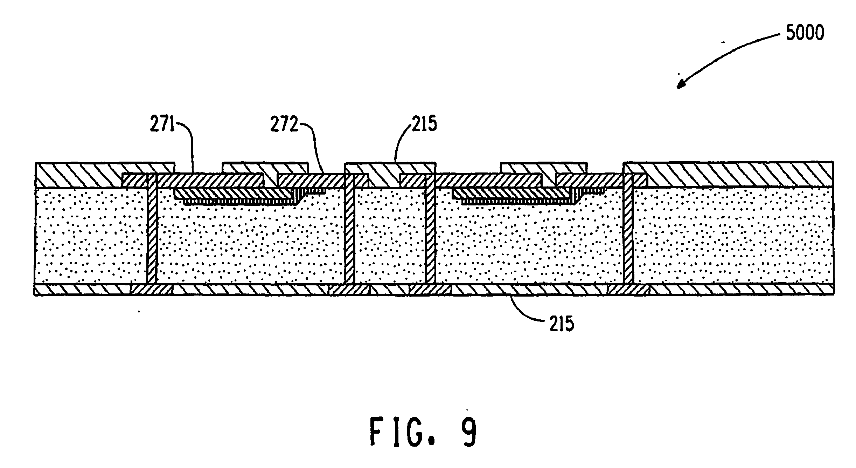

**FIG. 9** represents a section view in front elevation after soldermask **215** has been added to the article shown in **FIG. 8F** to form the photomask defined pads **271** and **272** of the final embodiment of power core **5000**.

The power core structure **5000** may be interconnected to at least one signal layer. The power core structure, therefore, may also have signal connection pads on its surface aligned with the semiconductor device signal terminals.

It should be understood that the power core **5000** may include additional layers and circuitry and may be formed by other sequences such as a combination of lamination and build-up processes

The power core device of the present invention comprise a power core structure that is interconnected through at least one signal layer. The device may comprise more than one signal layer wherein the signal layers are connect through conductive vias.

Examples of vertical interconnects (via-fill, printed, etched, plated bumps). where layers are built individually and then laminated in one step may be utilized in the present invention.

## Claims

1. An assembly comprising a power core, a semiconductor device (201) and a printed wiring motherboard, said power core having an outer layer, said power core comprising at least one embedded singulated capacitor layer containing multiple singulated capacitors wherein said multiple embedded singulated capacitors each comprise at least a first embedded singulated capacitor electrode (272) and a second embedded singulated capacitor electrode (270) and wherein said multiple embedded singulated capacitors are positioned on said outer layer of said power core and wherein said first embedded singulated capacitor electrodes (272) and said second embedded singulated capacitor electrodes (270) of said multiple embedded singulated capacitors of said at least one embedded singulated capacitor layer are each directly connected to at least one Vcc (power) terminal and at least one Vss (ground) terminal, respectively, of the semiconductor device (201) and **characterised in that** said first embedded singulated capacitor electrodes (272) and said second embedded singulated capacitor electrodes (270) of said multiple embedded singulated capacitors of said at least one embedded singulated capacitor layer are each interconnected to a first external planar capacitor electrode (285) and a second external planar capacitor electrode (280), respectively, of an external planar capacitor (340) embedded within the printed wiring motherboard on which said power core is placed and wherein said printed wiring motherboard serves to supply a charge to said multiple embedded singulated capacitors;
wherein the external planar capacitor embedded in the motherboard is larger than the power core.

2. The assembly of claim 1 wherein said semiconductor device (201) is a microprocessor.

3. The assembly of claim 1 wherein said power core is interconnected to at least one signal layer.

4. The assembly of any one of claims 1 through 3 wherein additional passive components are connected to and external to said power core.

## Patentansprüche

1. Baugruppe, die einen Leistungskern, ein Halbleiterbauelement (201) und eine gedruckte Verdrahtungsträgerleiterplatte umfasst, wobei der Leistungskern eine Außenschicht aufweist, wobei der Leistungskern mindestens eine eingebettete Vereinzelte-Kondensator-Schicht umfasst, die mehrere vereinzelte Kondensatoren enthält, wobei die mehreren eingebetteten vereinzelten Kondensatoren mindestens eine erste eingebettete Vereinzelte-Kondensator-Elektrode (272) und eine zweite eingebettete Vereinzelte-Kondensator-Elektrode (270) umfassen und wobei die mehreren eingebetteten vereinzelten Kondensatoren auf der Außenschicht des Leistungskerns positioniert sind und wobei die ersten eingebetteten Vereinzelten-Kondensator-Elektroden (272) und die zweiten eingebetteten Vereinzelten-Kondensator-Elektroden (270) der mehreren eingebetteten vereinzelten Kondensatoren der mindestens einen eingebetteten Vereinzelten-Kondensator-Schicht jeweils direkt mit mindestens einem Vcc-(Strom-) Anschluss bzw. mindestens einem Vss-(Masse-) Anschluss des Halbleiterbauelements (201) verbunden sind und **dadurch gekennzeichnet sind, dass** die ersten eingebetteten Vereinzelten-Kondensator-Elektroden (272) und die zweiten eingebetteten Vereinzelten-Kondensator-Elektroden (270) der mehreren eingebetteten vereinzelten Kondensatoren der mindestens einen eingebetteten Vereinzelten-Kondensator-Schicht jeweils mit einer ersten externen planaren Kondensatorelektrode (285) bzw. einer zweiten externen planaren Kondensatorelektrode (280) eines externen planaren Kondensators (340) zusammengeschaltet sind, der in die gedruckte Verdrahtungsträgerleiterplatte eingebettet ist, auf der der Leistungskern platziert ist, und wobei die gedruckte Verdrahtungsträgerleiterplatte dazu dient, an die mehreren eingebetteten vereinzelten Kondensatoren eine Ladung zu liefern;
wobei der in der Trägerleiterplatte eingebettete externe planare Kondensator größer ist als der Leistungskern.

2. Baugruppe nach Anspruch 1, wobei das Halbleiterbauelement (201) ein Mikroprozessor ist.

3. Baugruppe nach Anspruch 1, wobei der Leistungskern mit mindestens einer Signalschicht zusammengeschaltet ist.

4. Baugruppe nach einem der Ansprüche 1 bis 3, wobei zusätzliche passive Komponenten mit dem Leistungskern verbunden sind und sich außerhalb dieses befinden.

## Revendications

1. Ensemble, comprenant un coeur d'alimentation, un composant à semiconducteur (201) et une carte mère de circuit imprimé, ledit coeur d'alimentation possédant une couche extérieure, ledit coeur d'alimentation comprenant au moins une couche de condensateurs individuels intégrés contenant une pluralité de condensateurs individuels, chacun de laquelle pluralité de condensateurs individuels intégrés comprend au moins une première électrode (272) de condensateur individuel intégré et une deuxième électrode (270) de condensateur individuel intégré, et laquelle pluralité de condensateurs individuels intégrés est placée sur ladite couche extérieure dudit coeur d'alimentation, et chacune desquelles premières électrodes (272) de condensateurs individuels intégrés et desquelles deuxièmes électrodes (270) de condensateurs individuels intégrés de ladite pluralité de condensateurs individuels intégrés de ladite au moins une couche de condensateurs individuels intégrés est directement connectée respectivement à au moins une borne (d'alimentation) Vcc et à au moins une borne (de masse) Vss du composant à semiconducteur (201), et
l'ensemble étant **caractérisé en ce que** chacune desdites premières électrodes (272) de condensateurs individuels intégrés et desdites deuxièmes électrodes (270) de condensateurs individuels intégrés de ladite pluralité de condensateurs individuels intégrés de ladite au moins une couche de condensateurs individuels intégrés est interconnectée respectivement à une première électrode (285) de condensateur planar externe et à une deuxième électrode (280) de condensateur planar externe d'un condensateur planar externe (340) intégré à la carte mère de circuit imprimé sur laquelle ledit coeur d'alimentation est placé, laquelle carte mère de circuit imprimé sert à fournir une charge à ladite pluralité de condensateurs individuels intégrés ;
lequel condensateur planar externe intégré à la carte mère étant plus grand que le coeur d'alimentation.

2. Ensemble selon la revendication 1, ledit composant à semiconducteur (201) étant un microprocesseur.

3. Ensemble selon la revendication 1, ledit coeur d'alimentation étant interconnecté à au moins une couche de signaux.

4. Ensemble selon l'une quelconque des revendications 1 à 3, des composants passifs supplémentaires étant connectés audit coeur d'alimentation et extérieurs à celui-ci.
